# EUROPÄISCHE PATENTANMELDUNG

(11) **EP 1 670 131 A2**
(43) Veröffentlichungstag der Anmeldung: **14.06.2006**
(21) Anmeldenummer: 05025504.1
(22) Anmeldetag: 23.11.2005
(51) Int. Cl.: H02M 7/797

(54) **Leistungshalbleitermodul mit verringerten parasitären Induktivitäten**

(30) Priorität: 09.12.2004 DE 102004059313
(71) Anmelder: Semikron Elektronik GmbH & Co. KG Patentabteilung, 90431 Nürnberg (DE)
(72) Erfinder: Schreiber, Dejan, 90408 Nürnbert (DE); Heilbronner, Heinricht, Dr., 90547 Stein (DE)

(57) **Zusammenfassung**

Es wird ein Leistungshalbleitermodul mit einem Gehäuse (30,32a,32b) und hierin angeordnet einem oder eine Mehrzahl von Halbbrückenschaltungsanordnungen vorgeschlagen. Jede Halbbrückenschaltungsanordnung weist hierbei einen ersten (TOP) und einen zweiten (BOT) Leistungsschalter (10,12) auf, wobei jeder dieser Leistungsschalter aus einem Leistungstransistor und einer zugeordneten Leistungsdiode (20,22) (Freilaufdiode) besteht. Das Leistungshalbleitermodul weist weiterhin einen Gleichstromanschluss (40) positiver (40) und einen Gleichstromanschluss (50) negativer Polarität auf. Je Halbbrückenschaltungsanordnung weist es weiterhin zwei elektrisch nicht direkt miteinander verbundene Wechselstromanschlüsse (62,64) auf. Jeder TOP- Transistor ist mit der Leistungsdiode des BOT- Schalters und einem ersten Wechselstromanschluss verbunden und jeder BOT- Transistor ist mit der Leistungsdiode des TOP- Schalters und einem zweiten Wechselstromanschluss verbunden.

## Beschreibung

Es wird ein Leistungshalbleitermodul vorgestellt, wobei die parasitären Induktivitäten im Inneren des Leistungshalbleitermoduls gegenüber Standardleistungshalbleitermodulen verringert sind. Hierbei sollen Leistungshalbleitermodule betrachtet werden, deren interne Schaltungsanordnung als Halbbrückenschaltung ausgestaltet ist. Ebenfalls betrachtet werden derartige Leistungshalbleitermodule, deren interne Schaltungsanordnung als eine Parallelschaltung aus mehreren Halbbrückenschaltungen, hierunter fallen beispielhaft Vollbrückenschaltungen sowie Dreiphasenbrückenschaltungen, oder aus einer Parallelschaltung mehrerer geeigneter Teilschaltungen von Halbbrücken ausgestaltet ist. Der vielfältige Stand der Technik hierzu wird beispielhaft gebildet aus der DE 39 37 045 A1 und der DE 100 37 533 C1.

In der DE 39 37 045 wird für eine Halbbrücke eine Schaltungsanordnung zur Reduzierung der parasitären Induktivitäten in den Gleichstromzuleitungen beschrieben. Hierbei werden die beiden Gleichstromzuleitungen eng benachbart, allerdings mit der Wechselstromzuleitung zwischen Plus- und Minuszuleitung, und zumindest teilweise parallel zueinander angeordnet. Dies bewirkt eine Verkleinerung der stromumflossenen Fläche in dem Bereich der eng benachbarten Anordnung der Zuleitungen und damit eine relativ geringe Induktivität dieses Zuleitungsabschnittes.

In der DE 39 37 045 wird das Ziel einer minimalen parasitären Induktivität aus zwei wesentlichen Gründen allerdings verfehlt. Erstens sind die Gleichstromanschlussleiter nicht in minimalem Abstand zueinander angeordnet, da hier der Wechselstromanschlussleiter zwischen den beiden Gleichstromanschlussleitern angeordnet ist. Somit ist die stromumflossene Fläche im Bereich der Gleichstromanschlussleiter nicht minimal und daher sind auch die Induktivitäten für diesen Bereich nicht minimal. Zweitens sind die ersten und zweiten Leistungsschalters relativ weit von einander entfernt angeordnet, was ebenfalls die parasitären Induktivitäten erhöht.

Die DE 100 37 533 C1 offenbart eine modernere, sehr aufwändige, aber auch sehr wirksame Schaltungsanordnung zur Reduktion der parasitären Induktivitäten. Hierbei werden alle stromumflossenen Flächen innerhalb eines Leistungshalbeitermoduls soweit als möglich minimiert. Nachteilig hierbei ist der erhebliche konstruktive und Herstellungsaufwand einer derartigen Ausgestaltung eines Leistungshalbleitermoduls.

Allen Leistungshalbleitermodulen gemäß des beschriebenen Standes der Technik weisen je Halbbrückenschaltung einen Wechselspannungsausgang auf. Dies ist insofern nachteilig, wenn die äußere Beschaltung des Leistungshalbleitermoduls unterschiedlich ausgestaltet sein soll, in Abhängigkeit davon ob der Strom über den ersten (TOP-) oder den zweiten (BOT-) Zweig der jeweiligen Halbbrücke fließt.

Der Erfindung liegt die Aufgabe zugrunde ein Leistungshalbleitermodul vorzustellen, das geringe parasitäre Induktivitäten aufweist, einer einfachen Herstellung zugänglich ist und eine zusätzliche flexible Beschaltung des Wechselstromausgangs erlaubt.

Die Aufgabe wird erfindungsgemäß gelöst, durch die Maßnahmen der Merkmale der Ansprüche 1 und 2. Bevorzugte Ausführungsformen sind in den Unteransprüchen beschrieben.

Das erfindungsgemäße Leistungshalbleitermodul weist geringe parasitären Induktivitäten auf, allerdings basierend auf einer zum oben genannten Stand der Technik unterschiedlichen Ausgestaltung der Anordnung der einzelnen Komponenten.

Das Leistungshalbleitermodul selbst weist ein Gehäuse auf. In der ersten Ausgestaltung ist hierin eine oder eine Mehrzahl paralleler Halbbrückenschaltungsanordnungen angeordnet. Jede dieser Halbbrückenschaltungsanordnung weist einen ersten (TOP) und einen zweiten (BOT) Leistungsschalter auf, wobei jeder Leistungsschalter aus mindestens einem Leistungstransistor und mindestens einer zugeordneten Leistungsdiode einer sog. Freilaufdiode besteht. Das Leistungshalbleitermodul weist weiterhin mindestens einen Gleichstromanschluss positiver Polarität und mindestens einen Gleichstromanschluss negativer Polarität auf. Erfindungsgemäß weist jede in dem Leistungshalbleitermodul angeordnete Halbbrückenschaltungsanordnung mindestens zwei elektrisch im Inneren des Leistungshalbleitermoduls nicht direkt miteinander verbundene Wechselstromanschlüsse auf.

Die geringen parasitären Induktivitäten werden dadurch erreicht, dass je Halbbrückenschaltungsanordnung der mindestens eine TOP- Transistor mit der mindestens einen dem BOT- Schalters zugeordneten Leistungsdiode mit dem dieser Halbbrückenschaltungsanordnung zugeordneten ersten Wechselstromanschluss verbunden sind. Ebenso sind je Halbbrückenschaltungsanordnung der mindestens eine BOT-Transistor mit der mindestens einen Leistungsdiode des TOP- Schalters mit dem diese Halbbrückenschaltungsanordnung zugeordneten zweiten Wechselstromanschluss verbunden.

Das entscheidende Kriterium für geringe parasitäre Induktivitäten ist, dass während der Kommutierung, die hierbei stromumflossenen Flächen möglichst klein sind. Nach dem Stand der Technik ist dem TOP- Transistor dessen zugeordnete Freilaufdiode nahe benachbart angeordnet. Bei der Kommutierung, beispielsweise beim Ausschalten des TOP-Schalters, fließt der Strom durch den TOP- Transistor und anschließend durch die dem BOT- Schalter zugeordneten Freilaufdiode. Ebenso verhält es sich natürlich bei dem Ausschalten des BOT-Schalters mit der Freilaufdiode des TOP- Schalters. Durch die Anordnung des TOP- Transistors und der BOT- Freilaufdiode zu einem ersten Wechselstromanschluss und durch die entsprechende Anordnung des BOT- Transistors und der TOP- Freilaufdiode zu einem zweiten Wechselstromanschluss ist bei einem Kommutierungsvorgang die stromumflossene Fläche kleiner als bei der Anordnung nach dem Stand der Technik. Somit sind die parasitären Induktivitäten im Leistungshalbleitermodul verringert.

Die Trennung des einen Wechselstromanschlusses in jeweils einem dem TOP- und einem dem BOT- Transistor zugeordneten Wechselstromanschluss erlaubt weiterhin eine flexible äußere Beschaltung des Leistungshalbleitermoduls. Somit kann die Beschaltung des Wechselstromanschlusses unterschiedlich ausgestaltet sein, in Abhängigkeit davon ob der Strom über den ersten (TOP-) oder den zweiten (BOT-) Zeig der jeweiligen Halbbrückenschaltungsanordnung fließt.

In einer weiteren Ausgestaltung ist in dem Gehäuse (32) eine Mehrzahl von identischen Teilschaltungen einer Halbbrückenschaltungsanordnung angeordnet. Hierbei besteht eine vollständige Halbbrückenschaltungsanordnung wie oben beschrieben aus einem ersten (TOP) und einem zweiten (BOT) Leistungsschalter. Das Leistungshalbleitermodul weist mindestens einen Gleichstromanschluss positiver Polarität und mindestens einen Gleichstromanschluss negativer Polarität aufweist. Weiterhin weist jede Teilschaltung innerhalb einer ersten Ausgestaltung dieses Leistungshalbleitermoduls mindestens einem TOP- Transistor, mindestens eine Leistungsdiode des BOT- Schalters und einem Wechselstromanschluss auf, wobei diese Komponenten schaltungsgerecht miteinander verbunden sind. Alternativ weist eine zweite Ausgestaltung dieses Leistungshalbleitermoduls mindestens einen BOT- Transistor, mindestens eine Leistungsdiode des TOP- Schalters und einem Wechselstromanschluss auf, wobei diese Komponenten schaltungsgerecht miteinander verbunden sind

Der erfinderische Gedanke wird anhand der Ausführungsbeispiele in den Fig. 1 bis 4 näher erläutert.

Fig. 1 zeigt je ein Leistungshalbleitermodul mit einer Halb- bzw. einer Dreiphasenbrückenschaltungsanordnung nach dem Stand der Technik.

Fig. 2 zeigt ein erfindungsgemäßes Leistungshalbleitermodul mit einer Halbbrückenschaltungsanordnung.

Fig. 3 zeigt ein erfindungsgemäßes Leistungshalbleitermodul mit einer Dreiphasenbrückenschaltungsanordnung.

Fig. 4 zeigt eine weitere Ausgestaltung eines erfindungsgemäßen Leistungshalbleitermoduls mit einer Teilschaltung einer Dreiphasenbrückenschaltungsanordnung.

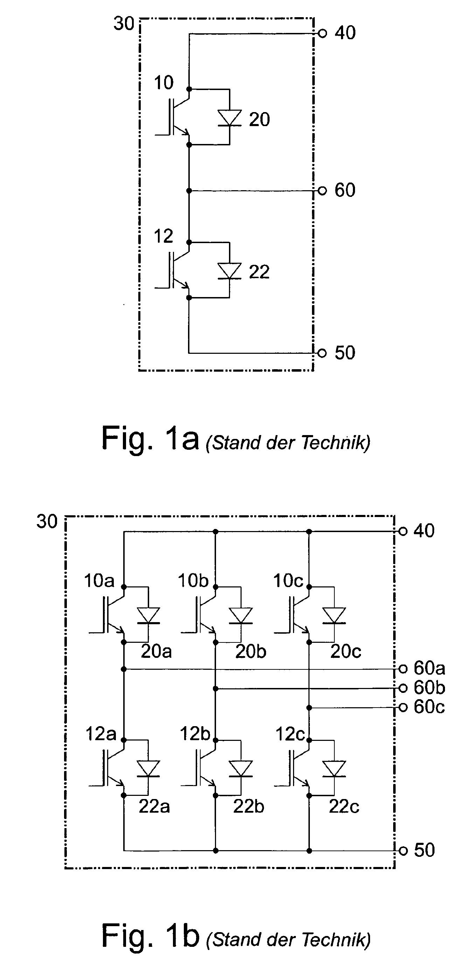

Fig. 1 zeigt schematisch den Stand der Technik von Leistungshalbleitermoduln mit einer Halb- bzw. einer Dreiphasenbrückenschaltungsanordnung. Fig. 1a zeigt hierbei schematisch ein Leistungshalbleitermodul mit einem Gehäuse (30). Darin angeordnet sind eine erste (TOP-) und ein zweiter (BOT-) Leistungsschalter. Die jeweiligen Leistungsschalter bestehen aus mindestens einem Leistungstransistor (10, 12), vorzugsweise einem IGBT (insulated gate bipolar transistor), und mindestens einer antiparallel geschalteten Freilaufdiode (20, 22), wobei die jeweiligen Transistoren und zugeordneten Freilaufdioden eng benachbart zueinander angeordnet sind. Der TOP- Schalter ist mit einem Gleichstromanschluss positiver Polarität (40) verbunden und der BOT- Schalter ist mit einem Gleichstromanschluss negativer Polarität (50) verbunden. Beide Schalter sind weiterhin miteinander und mit einem Wechselstromanschluss (60) verbunden.

Fig. 1 b zeigt ein weiteres Leistungshalbeitermodul mit einem Gehäuse. Darin sind drei Halbbrückenschaltungsanordnungen parallel angeordnet und bilden eine Dreiphasenbrückenschaltung. Jede dieser Halbbrücke ist wie zu Fig. 1a beschrieben ausgestaltet. Weiterhin sind die jeweiligen TOP- Schalter gemeinsam mit dem Gleichstromanschluss positiver Polarität (40) verbunden und die jeweiligen BOT- Schalter mit dem Gleichstromanschluss negativer Polarität (50) verbunden. Jede Halbbrückenschaltung ist mit einem eigenen aus dem Gehäuse (30) herausführenden Wechselstromanschluss (60 a, b, c) verbunden.

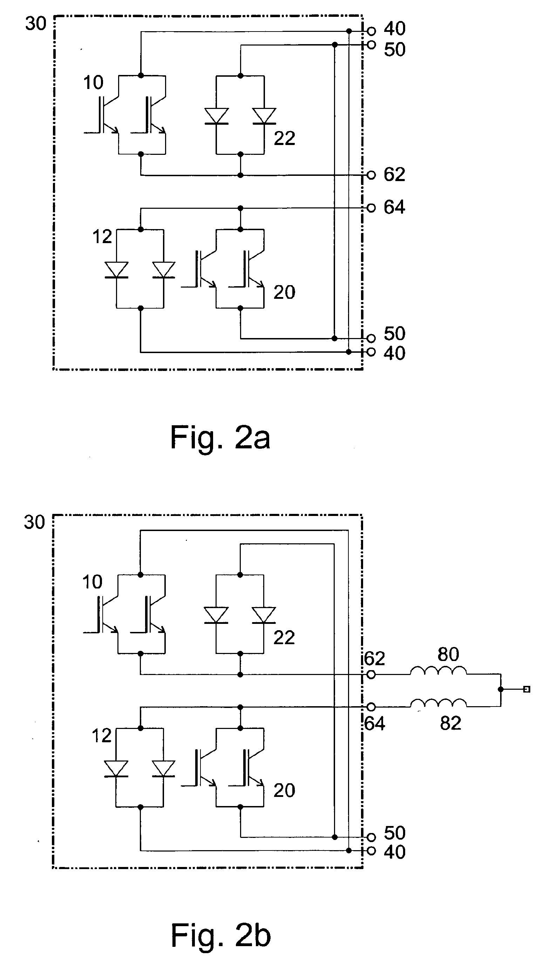

Fig. 2 zeigt ein erfindungsgemäßes Leistungshalbleitermodul mit einer Halbbrückenschaltungsanordnung. Fig. 2a zeigt hierbei schematisch ein Leistungshalbleitermodul mit einem Gehäuse (30) und einer Halbbrückenschaltungsanordnung. Hierbei besteht der TOP- Schalter aus zwei parallel geschalteten TOP- Transistoren (10), vorzugsweise IGBTs, und zwei zugeordneten ebenfalls parallel geschalteten Freilaufdioden (20). Analog hierzu besteht der BOT- Schalter aus zwei parallel geschalteten BOT- Transistoren (12) und zwei zugeordneten ebenfalls parallel geschalteten Freilaufdioden (22). Die Freilaufdioden jedes Schalters sind hier räumlich jeweils bei dem jeweils anderen Schalter angeordnet.

Es ist besonders bevorzugt, obwohl die Anordnung der Komponenten der Halbbrückenschaltungsanordnung dies bereits nahe legt die TOP- Transistoren (10) und die Freilaufdioden (22) des BOT- Schalters, ebenso wie die BOT- Transistoren (12) und die Freilaufdioden (20) des TOP- Schalters, eng benachbart zueinander anzuordnen. Dies verringert weiterhin die parasitären Induktivitäten des Leistungshalbleitermoduls.

Die Eingänge (Kollektoren) der TOP- Transistoren (10) sind mit einem ersten Gleichstromanschluss positiver Polarität (40) des Gehäuses (30) verbunden. Die Ausgänge (Emitter) sind mit dem ersten Wechselstromausgang (62) des Gehäuses und mit den Kathoden der Freilaufdioden (22) des BOT- Schalters verbunden. Die Anoden der Freilaufdioden (22) sind mit dem ersten Gleichstromanschluss negativer Polarität (50) des Gehäuses (30) verbunden. Analog ausgebildet ist die Anordnung aus BOT- Transistoren (12), Freilaufdioden (20) des TOP- Schalters und dem zweiten Wechselstromanschluss (64) des Gehäuses (30). Durch direkte externe Verbindung der beiden Wechselstromanschlüsse (62, 64) wird die identische Funktionalität eines Leistungshalbleitermoduls nach dem in Fig. 1a dargestellten Stand der Technik erreicht.

Fig. 2b zeigt eine weitere Ausgestaltung eines erfindungsgemäßen Leistungshalbleitermoduls mit einer Halbbrückenschaltungsanordnung. Die Anordnung der der Komponenten der Halbbrückenschaltung ist identisch denjenigen aus Fig. 2a. Demgegenüber weist das Leistungshalbleitermodul nur jeweils einen externen Gleichstromanschluss positiver (40) bzw. negativer (50) Polarität auf. Weiterhin ist hier dargestellt, dass der erste (62) und der zweite (64) Wechselstromausgang jeweils mit einer Spule (82, 84) beschaltet ist. Eine derartige Beschaltung ist beispielhaft angezeigt um bei einem Brückenkurzschluss eine Zerstörung der jeweiligen Schalter zu verhindern, da der Kurzschlussstrom durch die Spulen auf Grund des Induktionsgesetztes langsam ansteigt und somit eine Ansteuerschaltung die jeweiligen Schalt noch vor deren Zerstörung abschalten kann.

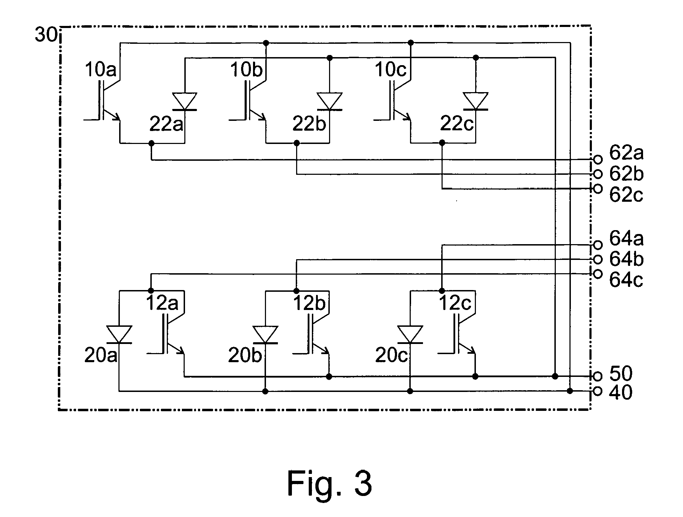

Fig. 3 zeigt ein erfindungsgemäßes Leistungshalbleitermodul mit einer Dreiphasenbrückenschaltungsanordnung. Dargestellt ist hierbei schematisch ein Leistungshalbleitermodul mit einem Gehäuse (30) und einer Dreiphasenbrückenschaltungsanordnung. Diese besteht aus einer parallelen Anordnung von drei Halbbrückenschaltungsanordnungen wie sie unter Fig. 2 beschrieben sind. Die Eingänge (Kollektoren) aller TOP- Transistoren (10 a, b, c)) aller drei Halbbrücken sind mit dem Gleichstromanschluss positiver Polarität (40) des Gehäuses (30) verbunden. Die Ausgänge (Emitter) sind je Halbbrücke mit je einem ersten Wechselstromausgang (62 a, b, c) des Gehäuses und mit den Kathoden der Freilaufdioden (22 a, b, c) der BOT- Schalter verbunden. Die Anoden der Freilaufdioden (22 a, b, c) sind mit dem Gleichstromanschluss negativer Polarität (50) des Gehäuses verbunden. Analog ausgebildet ist die Anordnung aus BOT- Transistoren (12 a, b, c), Freilaufdioden (20 a, b, c) des TOP- Schalters und dem je Halbbrücke zweiten Wechselstromanschluss (64 a, b, c) des Gehäuses.

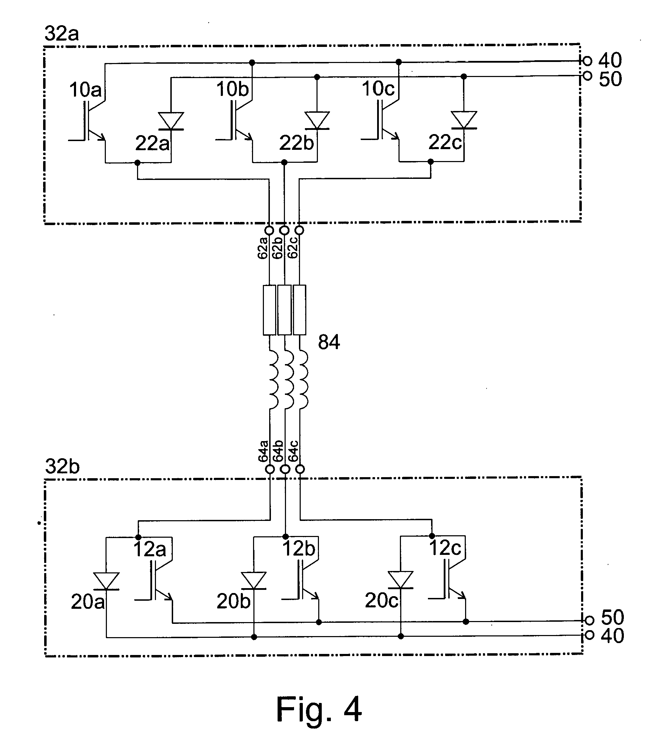

Fig. 4 zeigt eine weitere Ausgestaltung eines erfindungsgemäßen Leistungshalbleitermoduls. Hierbei ist in einem ersten Gehäuse (32a) eine erste Ausgestaltung und in einen zweiten Gehäuse eine zweite Ausgestaltung dargestellt. Die erste Ausgestaltung weist ein Gehäuse (32a) mit darin angeordneten ersten Teilschaltungen einer Dreiphasenbrückenschaltungsanordnung auf, wobei diese aus einer parallelen Anordnung des TOP- Transistors (10 a, b c) mit der Leistungsdiode (22 a, b, c) des BOT-Schalters und einem eigenen Wechselstromanschluss (62 a, b, c) besteht. Die zweite Ausgestaltung weist ein zweites Gehäuse (32b) mit darin angeordneten zweiten Teilschaltungen einer Dreiphasenbrückenschaltungsanordnung auf, wobei diese aus einer parallelen Anordnung des BOT- Transistors (12 a, b c) mit der Leistungsdiode (20 a, b, c) des TOP- Schalters und einem eigenen Wechselstromanschluss (64 a, b, c) besteht.

Ein hier dargestellter Reluktanzmotor (84) weist drei Rotorwicklungen auf. Hierbei ist der erste Anschluss der ersten Rotorwicklung mit dem Wechselstromausgang (62a) der ersten Teilschaltung der ersten Ausgestaltung des erfindungsgemäßen Leistungshalbleitermoduls verbunden. Der zweite Anschluss der ersten Rotorwicklung ist mit dem Wechselstromausgang (64a) der ersten Teilschaltung der zweiten Ausgestaltung des erfindungsgemäßen Leistungshalbleitermoduls verbunden. In analoger Weise sind die weiteren beiden Rotorwicklungen des Reluktanzmotors (84) mit den zweiten und dritten Teilschaltungen der Leistungshalbleitermodule verbunden.

Durch die erfindungsgemäße Ausbildung dieser beiden Ausgestaltungen des Leistungshalbleitermoduls ist es möglich die jeweils bei einem Kommutierungsvorgang beteiligten Komponenten einer Halbbrückenschaltung eng benachbart und damit geringe parasitäre Induktivitäten aufweisend in einem gemeinsamen Gehäuse (32 a, b) anzuordnen und weiterhin eine geeignete Verbindung zu einem Motor, hier einem Reluktanzmotor (84), zu gewährleisten.

## Patentansprüche

1. Leistungshalbleitermodul mit einem Gehäuse (30) und hierin angeordnet einem oder eine Mehrzahl von Halbbrückenschaltungsanordnungen mit pro Halbbrückenschaltungsanordnung einem ersten (TOP) und einem zweiten (BOT) Leistungsschalter,
wobei jeder Leistungsschalter aus mindestens einem Leistungstransistor (10, 12) und mindestens einer zugeordneten Leistungsdiode (Freilaufdiode) (20, 22) besteht,
und das Leistungshalbleitermodul mindestens einen Gleichstromanschluss (40) positiver Polarität, mindestens einen Gleichstromanschluss (50) negativer Polarität und je Halbbrückenschaltungsanordnung mindestens zwei elektrisch nicht direkt miteinander verbundene Wechselstromanschlüsse (62, 64) aufweist,
wobei jeweils der mindestens eine TOP- Transistor (10) mit der mindestens einen Leistungsdiode (22) des BOT- Schalters und dem ersten Wechselstromanschluss (62) verbunden ist und jeweils der mindestens eine BOT- Transistor (12) mit der mindestens einen Leistungsdiode (20) des TOP- Schalters und dem zweiten Wechselstromanschluss (64) verbunden ist.

2. Leistungshalbleitermodul mit einem Gehäuse (32 a, b) und hierin einer Mehrzahl von parallel angeordneten identischen Teilschaltungen einer Halbbrückenschaltungsanordnungen wobei eine Halbbrückenschaltungsanordnung aus einem ersten (TOP) und einem zweiten (BOT) Leistungsschalter besteht und, jeder Leistungsschalter aus mindestens einem Leistungstransistor (10, 12) und mindestens einer zugeordneten Leistungsdiode (Freilaufdiode) (20, 22) besteht, und das Leistungshalbleitermodul mindestens einen Gleichstromanschluss (40) positiver Polarität und mindestens einen Gleichstromanschluss (50) negativer Polarität aufweist. wobei jede Teilschaltung einer Halbbrückenschaltung besteht aus mindestens einem TOP- Transistor (10) mit der mindestens einer Leistungsdiode (22) des BOT- Schalters und einem Wechselstromanschluss (62), die schaltungsgerecht miteinander verbunden sind oder aus mindestens einem BOT- Transistor (12) mit der mindestens einen Leistungsdiode (20) des TOP- Schalters und einem Wechselstromanschluss (64) die schaltungsgerecht miteinander verbunden sind.

3. Leistungshalbleitermodul nach Anspruch 1 oder 2,
wobei alle TOP- Transistoren (10) eng benachbart zueinander und zu den Leistungsdiode (22) des BOT- Schalters bzw. alle BOT- Transistoren (12) eng benachbart zueinander und zu den Leistungsdiode (20) des TOP- Schalters angeordnet sind.

4. Leistungshalbleitermodul nach Anspruch 1 oder 2,
wobei die Transistoren (10, 12) als IGBTs (insulated gate bipolar transistor) ausgestaltet sind.
